# EUROPEAN PATENT APPLICATION

(11) **EP 4 524 968 A1**
(43) Date of publication of application: **19.03.2025**
(21) Application number: 23925884.1
(22) Date of filing: 01.06.2023
(51) Int. Cl.: G11C 29/22, G11C 29/38, G11C 29/26

(54) **MEMORY**

(30) Priority: 03.03.2023 CN 202310194644
(71) Applicant: CXMT Corporation, Hefei City, Anhui Province 230601 (CN)
(72) Inventor: WANG, Jia, Hefei, Anhui 230601 (CN)
(74) Representative: Gulde & Partner
(86) International application number: PCT/CN2023/097747
(87) International publication number: WO 2024/183170

(57) **Abstract**

A memory is disclosed, including a data input/output selector. A first input terminal of the data input/output selector receives serial data received by a target data input/output pin. The data input/output selector is configured to: in a test mode, separately transmit, to transmission paths corresponding to one corresponding data input/output pin in the memory, each bit of data in the serial data received by the target data input/output pin. The target data input/output pin is any one of multiple data input/output pins in the memory.

## Description

The present disclosure claims priority to Chinese Patent Application No. 202310194644.8, filed with the China National Intellectual Property Administration on March 3, 2023 and entitled "MEMORY", which is incorporated herein by reference in its entirety.

### TECHNICAL FIELD

The present disclosure relates to the field of memory technologies, and in particular, to a memory.

### BACKGROUND

With widespread application of various memories, e.g., widely applied dynamic random access memories (DRAM), in an actual application, a packaged memory needs to be tested to ensure product reliability.

Therefore, how to improve test efficiency of the memory becomes a problem that needs to be considered.

### SUMMARY

Embodiments of the present disclosure provide a memory, to improve test efficiency of the memory.

According to some embodiments, the present disclosure provides a memory, including:
a data input/output selector, a first input terminal of the data input/output selector receiving serial data received by a target data input/output pin,
the data input/output selector being configured to: in a test mode, separately transmit, to transmission paths corresponding to one corresponding data input/output pin in the memory, each bit of data in the serial data received by the target data input/output pin, and
the target data input/output pin being any one of multiple data input/output pins in the memory.

In the memory provided in the present disclosure, the first input terminal of the data input/output selector receives serial data received by any one of the multiple data input/output pins in the memory, and in the test mode, separately transmits, to transmission paths corresponding to one corresponding data input/output pin in the memory, each bit of data in the serial data received by the any one data input/output pin. Based on the foregoing memory, in a test process of the memory, write data may be received through one data input/output pin in the memory, so that a quantity of utilized data input/output pins in the memory in the test process is reduced, thereby increasing a quantity of simultaneously tested memories, and improving test efficiency.

### BRIEF DESCRIPTION OF DRAWINGS

The accompanying drawings herein, which are incorporated in and constitute a part of the specification, illustrate embodiments consistent with the present disclosure, and serve to explain the principles of the embodiments of the present disclosure together with the specification.
FIG. 1 is an example diagram of a pin architecture of a memory according to an embodiment of the present disclosure;
FIG. 2 is a schematic diagram of transmitting read and write data according to an embodiment of the present disclosure;
FIG. 3 is an example structural diagram of a memory according to an embodiment of the present disclosure;
FIG. 4 is an example structural diagram of a memory according to an embodiment of the present disclosure;
FIG. 5 is a schematic diagram of transmitting write data according to an embodiment of the present disclosure.

The foregoing accompanying drawings already show clear embodiments of the present disclosure, which are described in more detail below. These accompanying drawings and text descriptions are not intended to limit the scope of the concept of the present disclosure in any manner, but to describe the concept of the present disclosure for a person skilled in the art with reference to specific embodiments.

### DESCRIPTION OF EMBODIMENTS

Example embodiments are described in detail herein, and examples thereof are shown in the accompanying drawings. When the following descriptions relate to the accompanying drawings, unless otherwise indicated, the same numbers in different accompanying drawings represent the same or similar elements. Implementations described in the following example embodiments do not represent all implementations consistent with the present disclosure. On the contrary, they are merely examples of apparatuses and methods that are consistent with some aspects of the present disclosure.

The terms "include" and "have" in the present disclosure are utilized to denote an open-ended inclusion, and indicate that other elements/components/etc. can be present in addition to the elements/components/etc. listed. The terms "first", "second", and the like are utilized only for labeling purposes, and do not limit the quantity of objects thereof. In addition, different elements and areas in the accompanying drawings are merely shown schematically. Therefore, the present disclosure is not limited to a size or a distance shown in the accompanying drawings.

The following describes the technical solutions of the present disclosure in detail through specific embodiments. The following several specific embodiments may be combined with each other. A same or similar concept or process may not be described in some embodiments. The following describes the embodiments of the present disclosure with reference to the accompanying drawings.

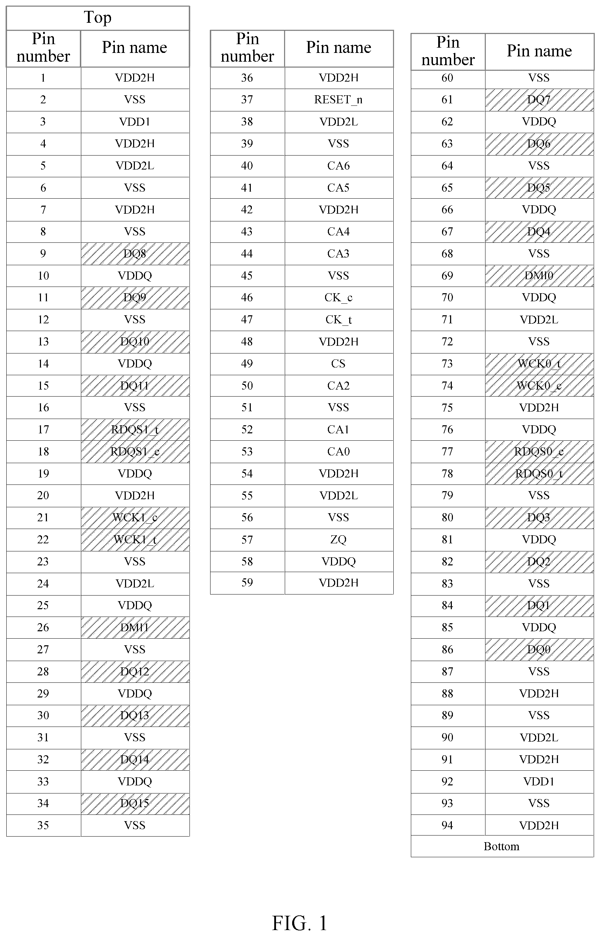

FIG. 1 is an example diagram of a pin architecture of a memory according to an embodiment of the present disclosure. As shown in FIG. 1, the memory includes multiple pins, and the multiple pins may be classified into power pins, data/address pins, and control command pins.

The power pins may include a VDD1 pin, a VDD2H pin, a VDD2L pin, and a VDDQ pin. The VDD1 pin receives VDD1 to supply power to a memory core. The VDD2H pin receives VDD2H to supply power to the memory core. The VDD2L pin receives VDD2L to supply power to the memory core as well. The VDDQ pin receives VDDQ to supply power to an I/O buffer. In an actual application, the memory may internally have three sets of voltages, which are respectively VDD1, VDD2, and VDDQ. VDD2 may include VDD2H and VDD2L. VDD1 and VDD2 represent working voltages of the memory core, and VDD1 and VDD2 have different voltage values. VDD2H represents a relatively high voltage value. VDD2L represents a relatively low voltage value. VDDQ represents a high-quality voltage subjected to noise filtering, with large anti-interference strength.

The data/address pins may include DQ0 to DQ15 pins and CA0 to CA6 pins. In an actual application, the memory internally includes a memory array, the memory array includes multiple memory cells, and each memory cell has a corresponding row and a corresponding column. During a read operation or a write operation, a row and a column of the memory array on which read or write is to be performed need to be first specified to determine a memory cell on which read or write is to be performed. The CA0 to CA6 pins may receive read addresses or write addresses. The read address includes a row and a column of the memory array on which read is performed, and the write address includes a row and a column of the memory array on which write is performed. The DQ0 to DQ15 pins may receive write data and output read data. During a read operation, the DQ0 to DQ15 pins output data read from the memory cell. During a write operation, the DQ0 to DQ15 pins receive data to be written into the memory cell.

The control command pins may include WCK pins, RDQS pins (also referred to as read data strobe pins), DMI pins, CK pins, and the like. The WCK pins include a WCK1_t pin, a WCK1_c pin, a WCK0_t pin, and a WCK0_c pin. The RDQS pins include an RDQS1_t pin, an RDQS1_c pin, an RDQS0_t pin, and an RDQS0_c pin. The DMI pins include a DMIO pin and a DMI1 pin. The CK pins include a CK_t pin and a CK_c pin. The WCK1_t pin receives WCK1_t. The WCK1_c pin receives WCK1_c. The WCK0_t pin receives WCK0_t. The WCK0_c pin receives WCK0_c. The RDQS1_t pin receives RDQS1_t. The RDQS1_c pin receives RDQS1_c. The RDQS0_t pin receives RDQS0_t. The RDQS0_c pin receives RDQS0_c. The DMIO pin receives DMIO. The DMI1 pin receives DMI1. The CK_t pin receives CK_t. The CK_c pin receives CK_c.

WCK1_t, WCK1_c, WCK0_t, and WCK0_c represent write clocks, and the write clocks are configured to sample the write data received by DQ0 to DQ15. In an actual application, WCK1_t and WCK1_c are configured to sample write data received by the DQ8 to DQ15 pins, and WCK0_t and WCK0_c are configured to sample write data received by DQ0 to DQ7 pins. WCK1_t, WCK1_c, WCK0_t, and WCK0_c may run at twice or four times a frequency of CK_t/CK_c to increase a sampling rate. RDQS1_t, RDQS1_c, RDQS0_t, and RDQS0_c represent read clocks, and are also referred to as read data strobe signals. The read clocks are configured to sample the read data output by DQ0 to DQ15. In an actual application, RDQS1_t and RDQS1_c are configured to sample read data output by the DQ8 to DQ15 pins, and RDQS0_t and RDQS0_c are configured to sample read data output by the DQ0 to DQ7 pins.

DMI1 and DMIO represent data mask (DM) signals, and the data mask signals are configured to mask the write data received by the DQ0 to DQ15 pins, to determine write data to be written into the memory cell. In an actual application, DMI1 is configured to mask write data received by the DQ8 to DQ15 pins, and DMIO is configured to mask write data received by the DQ0 to DQ7 pins.

CK_t and CK_c represent command address clocks, and the command address clocks are configured to sample the read address or the write address. In an actual application, all commands, addresses, and input control signals are sampled at an intersection of a rising edge of CK_t and a falling edge of CK_c.

The control command pins may further include a ZQ pin, a RESET pin, a CS pin, and the like. The ZQ pin receives ZQ. ZQ represents a calibration signal, and the calibration signal is configured to calibrate output drive strength. The RESET_n pin receives RESET_n. RESET_n represents a reset signal, and the reset signal is configured to reset the memory to a default state during initialization. The CS pin receives CS. CS represents a chip select signal, and the chip select signal is configured to select a target die.

It should be noted that pins related to data input/output include the DQ0 to DQ15 pins, the WCK1_t pin, the WCK1_c pin, the WCK0_t pin, the WCK0_c pin, the RDQS1_t pin, the RDQS1_c pin, the RDQS0_t pin, the RDQS0_c pin, the DMI1 pin, and the DMIO pin. It may be learned that 26 pins are related to data input/output.

In an actual application, to ensure reliability of a memory product, the memory needs to be tested after the memory is packaged. A memory test involves write and read on the memory, and the write and the read on the memory depend on pins of the memory.

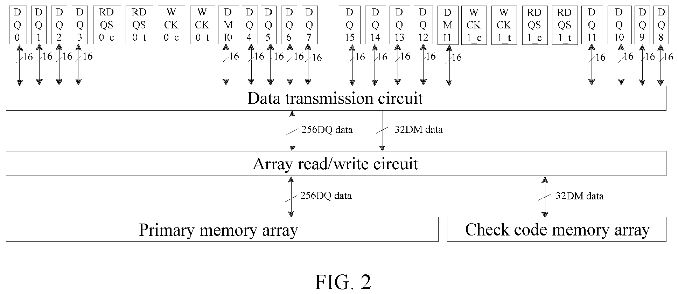

As shown in FIG. 2, FIG. 2 is an example diagram of transmitting read and write data according to an embodiment of the present disclosure. Taking a write scenario as an example, each of the DQ0 to DQ15 pins receives 16-bit write data, the WCK0_t pin receives WCK0_t, the WCK0_c pin receives WCK0_c, WCK0_t and WCK0_c are configured to sample the write data received by the DQ0 to DQ7 pins, the WCK1_t pin receives WCK1_t, the WCK1_c pin receives WCK1_c, and WCK1_t and WCK1_c are configured to sample the write data received by the DQ8 to DQ15 pins.

As shown in FIG. 2, when the memory is in a test mode, each DQ pin receives 16-bit write data, and 256-bit data is received by the DQ0 to DQ15 pins in total and stored into a primary memory array. 16-bit check code data is received by each of the DMIO pin and the DMI1 pin and stored into a check code memory array.

A data transmission circuit (data path circuit) transmits, to an array read/write circuit, the 256-bit data received by the DQ0 to DQ15 pins, the 16-bit check code data received by the DMIO pin, and the 16-bit check code data received by the DMI1 pin.

Taking a read scenario in the test mode of the memory as an example, the array read/write circuit reads data from the primary memory array and reads check code data from the check code memory array, and transmits the data to the data transmission circuit. The data transmission circuit transmits the read data to the DQ pin, and transmits the check code data to the DMI pin. As shown in FIG. 2, the array read/write circuit reads 256-bit data from 256 memory cells of the primary memory array and reads 32-bit check code data from 32 memory cells of the check code memory array, and transmits the 256-bit data and the 32-bit check code data to the data transmission circuit. The data transmission circuit transmits each piece of 16-bit data to each of the DQ0 to DQ15 pins, and separately transmits the two pieces of 16-bit check code data to the DMIO pin and the DMI1 pin. Then, the RDQS0_t pin receives RDQS0_t, the RDQS0_c pin receives RDQS0_c, RDQS0_t and RDQS0_c are configured to sample the read data output by the DQ0 to DQ7 pins. The RDQS1_t pin receives RDQS1_t, the RDQS1_c pin receives RDQS1_c, and RDQS1_t and RDQS1_c are configured to sample the read data output by the DQ8 to DQ15 pins.

In a test process of the memory, if data transmission, signal transmission, or the like is performed through all pins, a quantity of simultaneously tested memories is limited, and test efficiency is reduced.

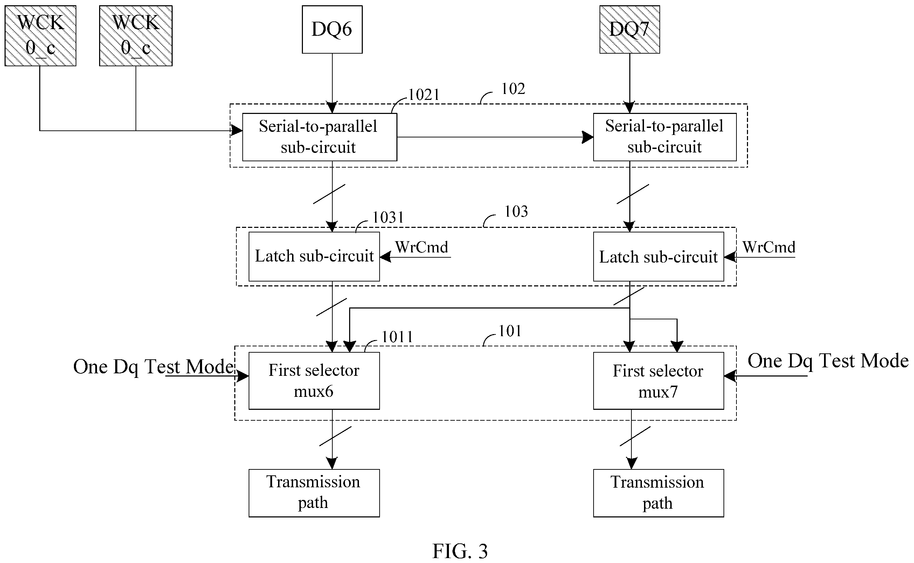

FIG. 3 is an example structural diagram of a memory according to an embodiment of the present disclosure. The memory provided in this embodiment is configured to reduce a quantity of utilized pins of the memory in a test process. As shown in FIG. 3, the memory includes a data input/output selector 101. A first input terminal of the data input/output selector 101 receives serial data received by a target data input/output pin. The target data input/output pin may be any one of multiple data input/output pins in the memory. The data input/output selector 101 is configured to: in a test mode, transmit, to transmission paths corresponding to one corresponding data input/output pin in the memory, each bit of data in the serial data received by the target data input/output pin. In the test mode, the serial data received by the target data input/output pin is transmitted to the transmission paths corresponding to each data input/output pin, and the same data is written into all memory cells corresponding to each data input/output pin. Therefore, in the test mode, write data needs to be received only through the target data input/output pin. In this way, only one data input/output pin is required during a test, so that a quantity of utilized data input/output pins is reduced, thereby increasing a quantity of simultaneously tested memories, and improving test efficiency.

The transmission path corresponding to the data input/output pin is a path for transmitting, to the memory cell, e.g. the data transmission circuit and the array read/write circuit in the foregoing embodiment, write data received by the data input/output pin. Because each data input/output pin may receive one piece of multi-bit serial data, only 1-bit data can be written into each memory cell, and serial data received by each data input/output pin may be written into multiple memory cells, each data input/output pin may correspond to multiple transmission paths.

In the test mode, a primary memory array in the memory may receive and store, through the multiple transmission paths corresponding to each data input/output pin, the serial data received by the target data input/output pin. Therefore, in the primary memory array, multiple memory cells corresponding to the multiple transmission paths of each data input/output pin store the same data in the serial data received by the target data input/output pin, i.e. the multiple memory cells store the same data.

In an actual application, the memory provided in this embodiment may be applied to tests of various memory chips. For example, the memory may be applied to, including but not limited to, a low power double data rate synchronous dynamic random access memory (LPDDR SDRAM), e.g., LPDDR5. The memory in this embodiment may be considered as a device under test (DUT).

In some embodiments, the data input/output selector 101 further includes a second input terminal. The second input terminal receives multiple pieces of serial data received by the multiple data input/output pins in the memory. It may be understood that the memory includes multiple data input/output pins, e.g. DQ0 to DQ15 pins. Each data input/output pin may receive one piece of multi-bit serial data. In this case, the data input/output selector 101 may receive the multiple pieces of serial data received by the multiple data input/output pins. That is, the data input/output selector 101 may receive one piece of multi-bit serial data received by each data input/output pin in the memory, and in a working mode, separately transmit, to the transmission paths corresponding to each data input/output pin, the one piece of multi-bit serial data received by the data input/output pin. The working mode may be a write operation in a non-test mode. In this embodiment, in the test mode, the memory may separately transmit, to the transmission paths corresponding to the one corresponding data input/output pin, each bit of data in the serial data received by the target data input/output pin, thereby reducing a quantity of utilized pins in a test process, and improving test efficiency. In addition, in the working mode, the memory may separately transmit, to the transmission paths corresponding to the one corresponding data input/output pin, the serial data received by the data input/output pin, thereby ensuring normal working of the memory.

In this example, the data input/output selector 101 may receive the multiple pieces of serial data received by the multiple data input/output pins in the memory and multi-bit data in serial data received by any one of the data input/output pins. When the memory receives a test command (One Dq Test Mode) in the test mode, each bit of data in one piece of serial data received by any one of the data input/output pins is separately transmitted to the transmission paths corresponding to the one corresponding data input/output pin. When the memory is in the working mode, the serial data received by the one corresponding data input/output pin is separately transmitted to the transmission paths corresponding to the one corresponding data input/output pin.

Transmission paths corresponding to a specific data input/output pin into which each bit of data in the serial data received by the target data input/output pin is to be written may be determined based on a sequence of transmitting each bit of data in the serial data received by the target data input/output pin. For example, each bit of data in the serial data received by the target data input/output pin is successively written into transmission paths corresponding to each of the DQ0 to DQ15 pins based on a sequence of transmitting each bit of data in the serial data.

In some embodiments, as shown in FIG. 3, the data input/output selector 101 includes multiple first selectors 1011, each of the first selectors 1011 corresponds to one data input/output pin, a first input terminal of each of the first selectors 1011 receives 1-bit data in the serial data received by the target data input/output pin, and a second input terminal of each of the first selectors 1011 receives serial data received by a corresponding data input/output pin. Therefore, in the test mode, each first selector 1011 may transmit, to transmission paths corresponding to the corresponding data input/output pin, 1-bit data in the received serial data received by the target data input/output pin; and in the working mode, each first selector 1011 may further transmit, to transmission paths corresponding to the corresponding data input/output pin, the serial data received by the corresponding data input/output pin.

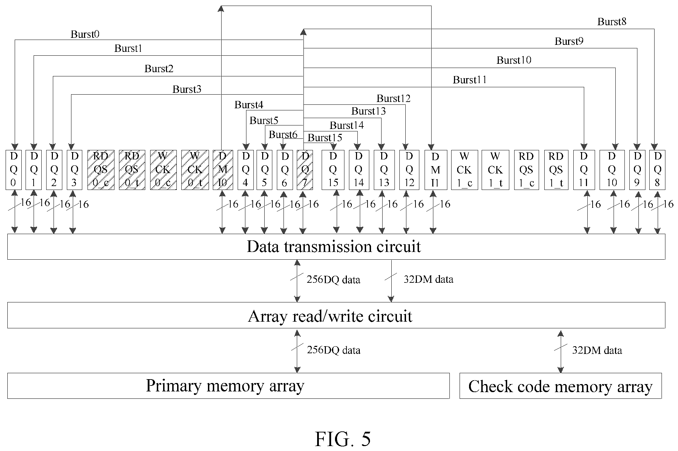

For example, FIG. 5 is an example diagram of transmitting write data according to an embodiment of the present disclosure. With reference to FIG. 3 and FIG. 5, FIG. 3 shows only the DQ6 pin and the DQ7 pin. It may be understood that the memory includes but is not limited to the DQ6 pin and the DQ7 pin. The memory may include 16 DQ pins in total, which are the DQ0 to DQ15 pins. The data input/output selector may include 16 first selectors, and the 16 first selectors are marked as mux0 to mux15. The DQ0 pin corresponds to mux0, the DQ1 pin corresponds to mux1, the DQ2 pin corresponds to mux2, the DQ3 pin corresponds to mux3, and so on, until the DQ15 pin corresponds to mux15. That the target data input/output pin is the DQ7 pin is taken as an example. A first input terminal of mux0 receives the first bit of data in serial data received by the DQ7 pin, and a second input terminal of mux0 receives serial data received by the DQ0 pin. A first input terminal of mux1 receives the second bit of data in the serial data received by the DQ7 pin, and a second input terminal of mux1 receives serial data received by the DQ1 pin. A first input terminal of mux2 receives the third bit of data in the serial data received by the DQ7 pin, and a second input terminal of mux2 receives serial data received by the DQ2 pin. A first input terminal of mux3 receives the fourth bit of data in the serial data received by the DQ7 pin, and a second input terminal of mux3 receives serial data received by the DQ3 pin. A first input terminal of mux4 receives the fifth bit of data in the serial data received by the DQ7 pin, and a second input terminal of mux4 receives serial data received by the DQ4 pin. A first input terminal of mux5 receives the sixth bit of data in the serial data received by the DQ7 pin, and a second input terminal of mux5 receives serial data received by the DQ5 pin. A first input terminal of mux6 receives the seventh bit of data in the serial data received by the DQ7 pin, and a second input terminal of mux6 receives serial data received by the DQ6 pin. A first input terminal of mux7 receives the eighth bit of data in the serial data received by the DQ7 pin, and a second input terminal of mux7 receives the serial data received by the DQ7 pin. A first input terminal of mux8 receives the ninth bit of data in the serial data received by the DQ7 pin, and a second input terminal of mux8 receives serial data received by the DQ8 pin. A first input terminal of mux9 receives the tenth bit of data in the serial data received by the DQ7 pin, and a second input terminal of mux9 receives serial data received by the DQ9 pin. A first input terminal of mux10 receives the eleventh bit of data in the serial data received by the DQ7 pin, and a second input terminal of mux10 receives serial data received by the DQ10 pin. A first input terminal of mux11 receives the twelfth bit of data in the serial data received by the DQ7 pin, and a second input terminal of mux11 receives serial data received by the DQ11 pin. A first input terminal of mux12 receives the thirteenth bit of data in the serial data received by the DQ7 pin, and a second input terminal of mux12 receives serial data received by the DQ12 pin. A first input terminal of mux13 receives the fourteenth bit of data in the serial data received by the DQ7 pin, and a second input terminal of mux13 receives serial data received by the DQ13 pin. A first input terminal of mux14 receives the fifteenth bit of data in the serial data received by the DQ7 pin, and a second input terminal of mux14 receives serial data received by the DQ14 pin. A first input terminal of mux15 receives the sixteenth bit of data in the serial data received by the DQ7 pin, and a second input terminal of mux15 receives serial data received by the DQ15 pin. Herein, "first", "second", and "sixteenth" each may be a sequence in which each bit of data in the serial data is transmitted to DQ7.

Correspondingly, in the test mode, mux0 transmits, to transmission paths corresponding to the DQ0 pin, the first bit of data in the serial data received by the DQ7 pin; mux1 transmits, to transmission paths corresponding to the DQ1 pin, the second bit of data in the serial data received by the DQ7 pin; mux2 transmits, to transmission paths corresponding to the DQ2 pin, the third bit of data in the serial data received by the DQ7 pin; mux3 transmits, to transmission paths corresponding to the DQ3 pin, the fourth bit of data in the serial data received by the DQ7 pin; mux4 transmits, to transmission paths corresponding to the DQ4 pin, the fifth bit of data in the serial data received by the DQ7 pin; mux5 transmits, to transmission paths corresponding to the DQ5 pin, the sixth bit of data in the serial data received by the DQ7 pin; mux6 transmits, to transmission paths corresponding to the DQ6 pin, the seventh bit of data in the serial data received by the DQ7 pin; mux7 transmits, to transmission paths corresponding to the DQ7 pin, the eighth bit of data in the serial data received by the DQ7 pin; mux8 transmits, to transmission paths corresponding to the DQ8 pin, the ninth bit of data in the serial data received by the DQ7 pin; mux9 transmits, to transmission paths corresponding to the DQ9 pin, the tenth bit of data in the serial data received by the DQ7 pin; mux10 transmits, to transmission paths corresponding to the DQ10 pin, the eleventh bit of data in the serial data received by the DQ7 pin; mux11 transmits, to transmission paths corresponding to the DQ11 pin, the twelfth bit of data in the serial data received by the DQ7 pin; mux12 transmits, to transmission paths corresponding to the DQ12 pin, the thirteenth bit of data in the serial data received by the DQ7 pin; mux13 transmits, to transmission paths corresponding to the DQ13 pin, the fourteenth bit of data in the serial data received by the DQ7 pin; mux14 transmits, to transmission paths corresponding to the DQ14 pin, the fifteenth bit of data in the serial data received by the DQ7 pin; and mux15 transmits, to transmission paths corresponding to the DQ15 pin, the sixteenth bit of data in the serial data received by the DQ7 pin.

In the working mode, mux0 transmits, to the transmission paths corresponding to the DQ0 pin, the serial data received by the DQ0 pin; mux1 transmits, to the transmission paths corresponding to the DQ1 pin, the serial data received by the DQ1 pin; mux2 transmits, to the transmission paths corresponding to the DQ2 pin, the serial data received by the DQ2 pin; mux3 transmits, to the transmission paths corresponding to the DQ3 pin, the serial data received by the DQ3 pin; mux4 transmits, to the transmission paths corresponding to the DQ4 pin, the serial data received by the DQ4 pin; mux5 transmits, to the transmission paths corresponding to the DQ5 pin, the serial data received by the DQ5 pin; mux6 transmits, to the transmission paths corresponding to the DQ6 pin, the serial data received by the DQ6 pin; mux7 transmits, to the transmission paths corresponding to the DQ7 pin, the serial data received by the DQ7 pin; mux8 transmits, to the transmission paths corresponding to the DQ8 pin, the serial data received by the DQ8 pin; mux9 transmits, to the transmission paths corresponding to the DQ9 pin, the serial data received by the DQ9 pin; mux10 transmits, to the transmission paths corresponding to the DQ10 pin, the serial data received by the DQ10 pin; mux11 transmits, to the transmission paths corresponding to the DQ11 pin, the serial data received by the DQ11 pin; mux12 transmits, to the transmission paths corresponding to the DQ12 pin, the serial data received by the DQ12 pin; mux13 transmits, to the transmission paths corresponding to the DQ13 pin, the serial data received by the DQ13 pin; mux14 transmits, to the transmission paths corresponding to the DQ14 pin, the serial data received by the DQ14 pin; and mux15 transmits, to the transmission paths corresponding to the DQ15 pin, the serial data received by the DQ15 pin.

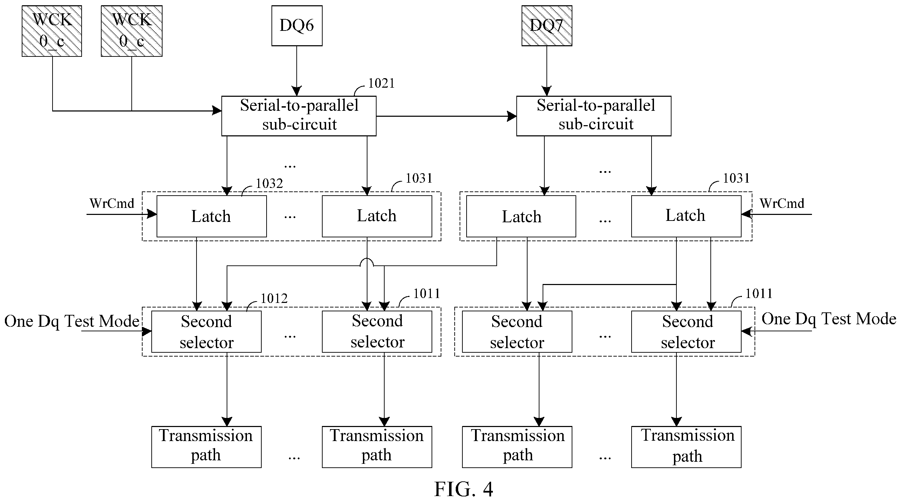

In this example, as shown in FIG. 4, each of the first selectors 1011 includes multiple second selectors 1012, and each of the second selectors 1012 corresponds to one transmission path of one data input/output pin. A first input terminal of each of the second selectors 1012 receives 1-bit data in the serial data received by the target data input/output pin, and a second input terminal of each of the second selectors 1012 receives 1-bit data in serial data received by a corresponding data input/output pin. It may be understood that each of the first selectors 1011 corresponds to one data input/output pin, and each of the first selectors 1011 includes multiple second selectors 1012. In this case, multiple second selectors 1012 in the same first selector 1011 correspond to the same data input/output pin. Each of the second selectors 1012 is configured to: in the test mode, transmit, to one transmission path of the corresponding data input/output pin, 1-bit data in the serial data received by the target data input/output pin; and in the working mode, transmit, to one transmission path of the corresponding data input/output pin, 1-bit data in the serial data received by the corresponding data input/output pin. In this embodiment, one transmission path of the data input/output pin may be understood as a transmission path of writing, into one memory cell, 1-bit data in serial data received by the data input/output pin.

In this example, that the DQ7 pin is the target data input/output pin is taken as an example. The DQ7 pin and the DQ6 pin each correspond to multiple second selectors. A first input terminal and a second input terminal of each of the second selectors corresponding to the DQ7 pin each receive 1-bit data in serial data received by the DQ7 pin. A first input terminal of each of the second selectors corresponding to the DQ6 pin receives 1-bit data in the serial data received by the DQ7 pin, and a second input terminal thereof receives 1-bit data in serial data received by the DQ6 pin. In the test mode, each of the second selectors corresponding to the DQ7 pin transmits the received 1-bit data in the serial data corresponding to the DQ7 pin to one transmission path of the DQ7 pin, and each of the second selectors corresponding to the DQ6 pin transmits the received 1-bit data in the serial data of the DQ7 pin to one transmission path of the DQ6 pin. In the working mode, each of the second selectors corresponding to the DQ7 pin transmits the received 1-bit data in the serial data corresponding to the DQ7 pin to one transmission path of the DQ7 pin, and each of the second selectors corresponding to the DQ6 pin transmits the received 1-bit data in the serial data corresponding to the DQ6 pin to one transmission path of the DQ6 pin.

In an actual application, during a write operation, the memory transmits data to one memory cell through one bit line, and only 1 bit can be written into one memory cell when data is written into the memory cell in the memory. For example, when data needs to be written into a memory cell, e.g. 1, a word line of a row in which the memory cell is located may be selected through a row decoder, to control a transistor M in the memory cell to be conducted. A logical level of the bit line is set to 1, so that a capacitor C is charged, i.e. 1 is written into the memory cell. On the contrary, if 0 is to be written, the logical level of the bit line is set to 0, so that the capacitor C is discharged, i.e. 0 is written to the memory cell.

Therefore, when the serial data received by the data input/output pin is written into the memory cell, the multi-bit serial data received by the data input/output pin may be first converted into multiple pieces of 1-bit parallel data, and the multi-bit serial data received by the data input/output pin is separately written into different memory cells at the same time through different bit lines in one write operation.

In some embodiments, the memory may include a serial-to-parallel circuit 102. As shown in FIG. 3, an input terminal of the serial-to-parallel circuit 102 is connected to the multiple data input/output pins. The serial-to-parallel circuit 102 may receive serial data received by each data input/output pin, and convert, into parallel data, the serial data received by each input/output pin. It may be understood that each data input/output pin has corresponding parallel data when the serial data received by the data input/output pin is converted into parallel data. The serial-to-parallel circuit 102 may convert, into parallel data based on write clock signals (WCK0_t and WCK0_c), the serial data received by each data input/output pin. In an actual application, WCK0_t may be received by a WCK0_t pin, WCK0_c may be received by a WCK0_c pin, and WCK0_t and WCK0_c are configured to sample serial data received by the DQ0 to DQ15 pins, to further reduce a quantity of utilized pins in the memory, and improve test efficiency.

Correspondingly, the second input terminal of the data input/output selector 101 may receive multiple pieces of parallel data corresponding to the multiple data input/output pins. In this case, in the test mode, the data input/output selector 101 may transmit each bit of data in parallel data corresponding to the target data input/output pin to the transmission paths corresponding to the one corresponding data input/output pin; and in the working mode, the data input/output selector 101 may further separately transmit parallel data corresponding to the one corresponding data input/output pin to the transmission paths corresponding to the one corresponding data input/output pin.

In this example, as shown in FIG. 3, the serial-to-parallel circuit 102 may include multiple serial-to-parallel sub-circuits 1021, an input terminal of each of the serial-to-parallel sub-circuits 1021 is connected to one data input/output pin, and each of the serial-to-parallel sub-circuits 1021 may convert, into parallel data, serial data received by a connected data input/output pin, so that the serial data received by each data input/output pin can be converted into parallel data.

In an actual application, after converting, into parallel data, the serial data received by the connected data input/output pin, each of the serial-to-parallel sub-circuits 1021 may transmit the parallel data to one corresponding first selector, and may further transmit each bit of data in the parallel data corresponding to the target data input/output pin to each first selector. For example, the first input terminal of each of the first selectors 1011 may successively receive 1-bit data in parallel data corresponding to the target data input/output pin based on a sequence of transmitting each bit of data in multi-bit serial data received by the target data input/output pin. Therefore, each of the first selectors 1011 can receive 1-bit data in the parallel data corresponding to the target data input/output pin. This reduces a possibility of a transmission error. Similarly, the second input terminal of each of the second selectors may successively receive 1-bit data in parallel data corresponding to a corresponding data input/output pin based on a sequence of transmitting each bit of data in multi-bit serial data received by the corresponding data input/output pin. Therefore, each of the second selectors can receive 1-bit data in the parallel data corresponding to the corresponding data input/output pin. This also reduces a possibility of a data transmission error.

That the target data input/output pin is the DQ7 pin is taken as an example. The serial-to-parallel circuit converts, into 16-bit parallel data, the 16-bit serial data received by each of the DQ0 to DQ15 pins. The 16-bit parallel data of the DQ7 pin is respectively denoted as burst0 to burst15. The serial-to-parallel circuit may separately transmit the 16-bit parallel data of the DQ7 pin to each of the first selectors, and may further transmit parallel data corresponding to the DQ0 to DQ15 pins to mux0 to mux15 respectively.

With reference to FIG. 3 and FIG. 5, the first input terminal of mux0 receives busrt0, and the second input terminal of mux0 receives parallel data corresponding to the DQ0 pin; the first input terminal of mux1 receives busrt1, and the second input terminal of mux1 receives parallel data corresponding to the DQ1 pin; the first input terminal of mux2 receives busrt2, and the second input terminal of mux2 receives parallel data corresponding to the DQ2 pin; the first input terminal of mux3 receives busrt3, and the second input terminal of mux3 receives parallel data corresponding to the DQ3 pin; the first input terminal of mux4 receives busrt4, and the second input terminal of mux4 receives parallel data corresponding to the DQ4 pin; the first input terminal of mux5 receives busrt5, and the second input terminal of mux5 receives parallel data corresponding to the DQ5 pin; the first input terminal of mux6 receives busrt6, and the second input terminal of mux6 receives parallel data corresponding to the DQ6 pin; the first input terminal of mux7 receives busrt7, and the second input terminal of mux7 receives parallel data corresponding to the DQ7 pin; the first input terminal of mux8 receives busrt8, and the second input terminal of mux8 receives parallel data corresponding to the DQ8 pin; the first input terminal of mux9 receives busrt9, and the second input terminal of mux9 receives parallel data corresponding to the DQ9 pin; the first input terminal of mux10 receives busrt10, and the second input terminal of mux10 receives parallel data corresponding to the DQ10 pin; the first input terminal of mux11 receives busrt11, and the second input terminal of mux11 receives parallel data corresponding to the DQ11 pin; the first input terminal of mux12 receives busrt12, and the second input terminal of mux12 receives parallel data corresponding to the DQ12 pin; the first input terminal of mux13 receives busrt13, and the second input terminal of mux13 receives parallel data corresponding to the DQ13 pin; the first input terminal of mux14 receives busrt14, and the second input terminal of mux14 receives parallel data corresponding to the DQ14 pin; and the first input terminal of mux15 receives busrt15, and the second input terminal of mux15 receives parallel data corresponding to the DQ15 pin.

Correspondingly, in the test mode, mux0 transmits burst0 to various transmission paths corresponding to the DQ0 pin, mux1 transmits burst1 to various transmission paths corresponding to the DQ1 pin, mux2 transmits burst2 to various transmission paths corresponding to the DQ2 pin, mux3 transmits burst3 to various transmission paths corresponding to the DQ3 pin, mux4 transmits burst4 to various transmission paths corresponding to the DQ4 pin, mux5 transmits burst5 to various transmission paths corresponding to the DQ5 pin, mux6 transmits burst6 to various transmission paths corresponding to the DQ6 pin, mux7 transmits burst7 to various transmission paths corresponding to the DQ7 pin, mux8 transmits burst8 to various transmission paths corresponding to the DQ8 pin, mux9 transmits burst9 to various transmission paths corresponding to the DQ9 pin, mux10 transmits burst10 to various transmission paths corresponding to the DQ10 pin, mux11 transmits burst11 to various transmission paths corresponding to the DQ11 pin, mux12 transmits burst12 to various transmission paths corresponding to the DQ12 pin, mux13 transmits burst13 to various transmission paths corresponding to the DQ13 pin, mux14 transmits burst14 to various transmission paths corresponding to the DQ14 pin, and mux15 transmits burst15 to various transmission paths corresponding to the DQ15 pin. It should be noted that, in the test mode, each bit of data in the parallel data corresponding to the DQ7 pin is transmitted to various transmission paths corresponding to each DQ pin. In this case, data written into memory cells corresponding to the transmission paths in each DQ pin is the same.

In the working mode, each second selector in mux0 transmits 1-bit data in the parallel data corresponding to the DQ0 pin to one transmission path corresponding to the DQ0 pin; each second selector in mux1 transmits 1-bit data in the parallel data corresponding to the DQ1 pin to one transmission path corresponding to the DQ1 pin; each second selector in mux2 transmits 1-bit data in the parallel data corresponding to the DQ2 pin to one transmission path corresponding to the DQ2 pin; each second selector in mux3 transmits 1-bit data in the parallel data corresponding to the DQ3 pin to one transmission path corresponding to the DQ3 pin; each second selector in mux4 transmits 1-bit data in the parallel data corresponding to the DQ4 pin to one transmission path corresponding to the DQ4 pin; each second selector in mux5 transmits 1-bit data in the parallel data corresponding to the DQ5 pin to one transmission path corresponding to the DQ5 pin; each second selector in mux6 transmits 1-bit data in the parallel data corresponding to the DQ6 pin to one transmission path corresponding to the DQ6 pin; each second selector in mux7 transmits 1-bit data in the parallel data corresponding to the DQ7 pin to one transmission path corresponding to the DQ7 pin; each second selector in mux8 transmits 1-bit data in the parallel data corresponding to the DQ8 pin to one transmission path corresponding to the DQ8 pin; each second selector in mux9 transmits 1-bit data in the parallel data corresponding to the DQ9 pin to one transmission path corresponding to the DQ9 pin; each second selector in mux10 transmits 1-bit data in the parallel data corresponding to the DQ10 pin to one transmission path corresponding to the DQ10 pin; each second selector in mux11 transmits 1-bit data in the parallel data corresponding to the DQ11 pin to one transmission path corresponding to the DQ11 pin; each second selector in mux12 transmits 1-bit data in the parallel data corresponding to the DQ12 pin to one transmission path corresponding to the DQ12 pin; each second selector in mux13 transmits 1-bit data in the parallel data corresponding to the DQ13 pin to one transmission path corresponding to the DQ13 pin; each second selector in mux14 transmits 1-bit data in the parallel data corresponding to the DQ14 pin to one transmission path corresponding to the DQ14 pin; and each second selector in mux15 transmits 1-bit data in the parallel data corresponding to the DQ15 pin to one transmission path corresponding to the DQ15 pin.

In some embodiments, the memory may further include a latch circuit 103. As shown in FIG. 3, an input terminal of the latch circuit 103 is connected to an output terminal of the serial-to-parallel circuit 102, and an output terminal of the latch circuit 103 is connected to the multiple first selectors 1011 in the data input/output selector 101. The latch circuit 103 can receive multiple pieces of parallel data that correspond to the multiple data input/output pins and that are transmitted by the serial-to-parallel circuit 102, store the multiple pieces of parallel data corresponding to the multiple data input/output pins, transmit each of the multiple pieces of parallel data corresponding to the multiple data input/output pins to a first selector 1011 corresponding to each data input/output pin after a write command (WrCmd) received, and further separately transmit each bit of data in the parallel data corresponding to the target data input/output pin to the first selector 1011 corresponding to each data input/output pin. Therefore, each of the first selectors 1011 can receive parallel data corresponding to one data input/output pin and 1-bit data in the parallel data corresponding to the target data input/output pin.

In this example, the latch circuit 103 may store the multiple pieces of parallel data corresponding to the multiple data input/output pins, separately transmit each bit of data in parallel data corresponding to any one of the data input/output pins to the first selector 1011 corresponding to each data input/output pin after the write command is received, and separately transmit the parallel data corresponding to each data input/output pin to the first selector 1011 corresponding to the data input/output pin.

The latch circuit 103 may include multiple latch sub-circuits 1031, an input terminal of each of the latch sub-circuits 1031 is connected to one serial-to-parallel sub-circuit 1021, and an output terminal of each of the latch sub-circuits 1031 is connected to one first selector 1011. Each of the latch sub-circuits 1031 may receive parallel data output by a corresponding serial-to-parallel sub-circuit, i.e. receive parallel data corresponding to one data input/output pin. After receiving parallel data corresponding to one data input/output pin, each of the latch sub-circuits 1031 stores parallel data corresponding to a corresponding data input/output pin, and transmits the parallel data corresponding to the corresponding data input/output pin to one corresponding first selector after the write command is received. In addition, after the write command is received, a latch sub-circuit 1031 corresponding to the target data input/output pin further transmits each bit of data in the parallel data corresponding to the target data input/output pin to the first selector 1011 corresponding to each data input/output pin. Therefore, each of the first selectors 1011 can receive parallel data of a corresponding data input/output pin, and can further receive 1-bit data in the parallel data corresponding to the target data input/output pin.

In this example, as shown in FIG. 4, each of the latch sub-circuits 1031 may include multiple latches 1032, each of the latches 1032 is connected to one of the second selectors 1012, each of the second selectors 1012 corresponds to one transmission path, and each latch corresponding to the target data input/output pin may be further connected to multiple second selectors corresponding to one data input/output pin. Each of the latch sub-circuits 1031 may receive parallel data corresponding to one data input/output pin, and each of the latches 1032 may receive 1-bit data in parallel data corresponding to one data input/output pin. After receiving the write command, each of the latches 1032 may transmit 1-bit data in parallel data of a corresponding data input/output pin to a connected second selector 1012. In addition, after receiving the write command, each latch 1032 corresponding to the target data input/output pin may not only transmit 1-bit data in the parallel data corresponding to the target data input/output pin to a second selector corresponding to the target data input/output pin, but also transmit 1-bit data in the parallel data corresponding to the target data input/output pin to multiple second selectors 1012 corresponding to one data input/output pin. Therefore, each of the second selectors 1012 can not only receive 1-bit data in parallel data of a corresponding data input/output pin, but also receive 1-bit data in the parallel data corresponding to the target data input/output pin.

In some embodiments, as shown in FIG. 5, the memory further includes a data mask pin DMIO/DMI1. The data mask pin is configured to: receive mask data when the memory performs a mask write operation, or receive check code data in the test mode. When the memory performs a mask write operation, the memory masks, based on mask data, data received by the data input/output pin. When the memory is in the test mode, the memory stores the check code data into a check code memory array. The memory masks, based on the check code data, the data received by the data input/output pin.

In this example, the memory further includes a check code data selector, the check code memory array includes a first check code memory array and a second check code memory array, and the data mask pin includes a first data mask pin and a second data mask pin. In the test mode, if the first data mask pin receives the check code data, the check code data selector transmits the check code data to transmission paths corresponding to the first data mask pin and the second data mask pin, the first check code memory array receives and stores the check code data through the transmission paths corresponding to the first data mask pin, and the second check code memory array receives and stores the check code data through the transmission paths corresponding to the second data mask pin.

A quantity of bits of the check code data is the same as a quantity of bits of the serial data received by each data input/output pin. In the test mode, the memory masks each bit of data in the serial data received by each data input/output pin based on each bit of data in the check code data. For example, both the check code data and the serial data received by the data input/output pin are 16-bit data, and each bit of data in the check code data is configured to mask 1-bit data in the serial data received by each data input/output pin.

In an actual application, the memory includes a DMIO pin and a DMI1 pin. Generally, mask data received by the DMIO pin is configured to control whether parallel data corresponding to the DQ0 to DQ7 pins is to be written into the primary memory array, and mask data received by the DMI1 pin is configured to control whether parallel data corresponding to the DQ8 to DQ15 pins is to be written into the primary memory array. In this embodiment, in the test mode, if the DMIO pin receives the check code data, the check code data selector may transmit, to transmission paths corresponding to the DMIO pin and transmission paths corresponding to the DMI1 pin, the check code data received by the DMIO pin. If the DMI1 pin receives the check code data, the check code data selector may transmit, to transmission paths corresponding to the DMIO pin and transmission paths corresponding to the DMI1 pin, the check code data received by the DMI1 pin. This reduces a quantity of utilized DMI pins in a test process, and improves test efficiency.

For example, the check code data selector may include multiple third selectors. In the test mode, each of the third selectors can transmit 1-bit data in the check code data to one transmission path corresponding to the first data mask pin and one transmission path corresponding to the second data mask pin, and the multiple third selectors can transmit each bit of data in the check code data to multiple transmission paths corresponding to the first data mask pin and multiple transmission paths corresponding to the second data mask pin.

In an actual application, serial check code data received by the data mask pin may be converted into parallel check code data. For example, the serial check code data is one piece of 16-bit serial data, and the 16-bit serial data is converted into 16-bit parallel data. Then, one of the third selectors transmits 1-bit data thereof to one transmission path corresponding to the first data mask pin and one transmission path corresponding to the second data mask pin.

The memory provided in the embodiments of the present disclosure is described in detail above. According to the memory provided in the embodiments of the present disclosure, during a test, serial data is received through one of multiple data input/output pins, and then each bit of data in the serial data is separately transmitted by the data input/output selector in the memory to transmission paths corresponding to one corresponding data input/output pin. Therefore, in a test process, a quantity of utilized data input/output pins in a semiconductor memory is reduced, and test efficiency is improved.

A person skilled in the art can easily figure out other implementation solutions of the present disclosure after considering the specification and practice of the present disclosure herein. The present disclosure is intended to cover any variations, functions, or adaptive changes of the present disclosure. These variations, functions, or adaptive changes comply with general principles of the present disclosure, and include common knowledge or a conventional technical means in the art that is not disclosed in the present disclosure.

It should be understood that the present disclosure is not limited to the precise structures described above and shown in the accompanying drawings, and various modifications and changes may be made without departing from the scope thereof.

## Claims

1. A memory, comprising:
a data input/output selector (101), a first input terminal of the data input/output selector receiving serial data received by a target data input/output pin,
the data input/output selector (101) being configured to: in a test mode, separately transmit, to transmission paths corresponding to one corresponding data input/output pin in the memory, each bit of data in the serial data received by the target data input/output pin, and
the target data input/output pin being any one of a plurality of data input/output pins in the memory.

2. The memory according to claim 1, wherein a second input terminal of the data input/output selector (101) receives a plurality of pieces of serial data received by the plurality of data input/output pins; and
the data input/output selector (101) is further configured to: in a working mode, separately transmit, to the transmission paths corresponding to the one corresponding data input/output pin, serial data received by the one corresponding data input/output pin.

3. The memory according to claim 2, wherein the data input/output selector (101) comprises a plurality of first selectors (1011), and each of the first selectors (1011) corresponds to one data input/output pin;
a first input terminal of each of the first selectors (1011) receives 1-bit data in the serial data received by the target data input/output pin, and a second input terminal of each of the first selectors (1011) receives serial data received by a corresponding data input/output pin; and
each of the first selectors (1011) is configured to: in the test mode, transmit, to various transmission paths of the corresponding data input/output pin, 1-bit data in the serial data received by the target data input/output pin; and in the working mode, transmit, to transmission paths of the corresponding data input/output pin, the serial data received by the corresponding data input/output pin.

4. The memory according to claim 3, wherein each of the first selectors (1011) comprises a plurality of second selectors (1012), and each of the second selectors (1012) corresponds to one transmission path of one data input/output pin;
a first input terminal of each of the second selectors (1012) receives 1-bit data in the serial data received by the target data input/output pin, and a second input terminal of each of the second selectors (1012) receives 1-bit data in serial data received by a corresponding data input/output pin; and
each of the second selectors (1012) is configured to: in the test mode, transmit, to one transmission path of the corresponding data input/output pin, 1-bit data in the serial data received by the target data input/output pin; and in the working mode, transmit, to one transmission path of the corresponding data input/output pin, 1-bit data in serial data received by the corresponding data input/output pin.

5. The memory according to claim 4, comprising:
a serial-to-parallel circuit (102), an input terminal of the serial-to-parallel circuit being connected to the plurality of data input/output pins, and the serial-to-parallel circuit being configured to convert, into parallel data, the serial data received by the one corresponding data input/output pin, and
the data input/output selector (101) being configured to: in the test mode, transmit, to the transmission paths corresponding to the one corresponding data input/output pin, each bit of data in parallel data corresponding to the target data input/output pin; and in the working mode, transmit, to the transmission paths corresponding to the one corresponding data input/output pin, parallel data corresponding to the one corresponding data input/output pin.

6. The memory according to claim 5, wherein the serial-to-parallel circuit (102) comprises a plurality of serial-to-parallel sub-circuits (1021), and an input terminal of each of the serial-to-parallel sub-circuits (1021) is connected to one data input/output pin; and
each of the serial-to-parallel sub-circuits (1021) is configured to convert, into parallel data, serial data received by a connected data input/output pin.

7. The memory according to claim 5 or 6, wherein the first input terminal of each of the first selectors (1011) successively receives 1-bit data in the parallel data corresponding to the target data input/output pin; and
the second input terminal of each of the second selectors (1012) successively receives 1-bit data in parallel data corresponding to a corresponding data input/output pin.

8. The memory according to any one of claims 5 to 7, wherein the memory comprises a latch circuit (103), an input terminal of the latch circuit is connected to the serial-to-parallel circuit (102), and an output terminal of the latch circuit is connected to the plurality of first selectors; and
the latch circuit (103) is configured to: store a plurality of pieces of parallel data corresponding to the plurality of data input/output pins, separately transmit the plurality of pieces of parallel data corresponding to the plurality of data input/output pins to corresponding first selectors (1011) after a write command is received, and separately transmit a plurality of bits of data in the parallel data corresponding to the target data input/output pin to corresponding first selectors (1011).

9. The memory according to claim 8, wherein the latch circuit (103) comprises a plurality of latch sub-circuits (1031), an input terminal of each of the latch sub-circuits (1031) is connected to an output terminal of one serial-to-parallel sub-circuit (1021), and an output terminal of each of the latch sub-circuits (1031) is connected to one first selector (1011);
each of the latch sub-circuits (1031) is configured to: store parallel data of a corresponding data input/output pin, and transmit the parallel data of the corresponding data input/output pin to a corresponding first selector (1011) after the write command is received; and
a latch sub-circuit (1031) corresponding to the target data input/output pin is further configured to each bit of data in the parallel data corresponding to the target data input/output pin to each of the first selectors (1011) after the write command is received.

10. The memory according to claim 9, wherein each of the latch sub-circuits (1031) comprises a plurality of latches (1032), and each of the latches (1032) is connected to one of the second selectors (1012);
each of the latches (1032) is configured to: store 1-bit data in parallel data of a corresponding data input/output pin, and transmit the stored 1-bit data to a connected second selector (1012) after the write command is received; and
each latch (1032) corresponding to the target data input/output pin is further configured to transmit 1-bit data in the parallel data corresponding to the target data input/output pin to a plurality of second selectors (1012) corresponding to one data input/output pin after the write command is received.

11. The memory according to any one of claims 1 to 10, further comprising:
a data mask pin, configured to: receive mask data when the memory performs a mask write operation, or receive check code data in the test mode, the memory masking, based on the mask data when the memory performs the mask write operation, data received by the data input/output pin, and storing the check code data into a check code memory array when the memory is in the test mode.

12. The memory according to claim 11, further comprising:
a check code data selector, the check code memory array comprising a first check code memory array and a second check code memory array, the data mask pin comprising a first data mask pin and a second data mask pin, the first data mask pin receiving the check code data in the test mode, the check code data selector separately transmitting the check code data to transmission paths corresponding to the first data mask pin and the second data mask pin, the first check code memory array receiving and storing the check code data through the transmission paths corresponding to the first data mask pin, and the second check code memory array receiving and storing the check code data through the transmission paths corresponding to the second data mask pin.

13. The memory according to any one of claims 1 to 12, wherein the memory comprises a primary memory array, and the primary memory array stores data on transmission paths corresponding to the data input/output pin.

14. The memory according to claim 12, wherein the check code data selector comprises a plurality of third selectors, and in the test mode, each of the third selectors transmits 1-bit data in the check code data to one transmission path corresponding to the first data mask pin and one transmission path corresponding to the second data mask pin.

15. The memory according to claim 13, wherein in the test mode, the primary memory array receives and stores, through the transmission paths corresponding to each of the data input/output pins, the serial data received by the target data input/output pin.
